# EUROPÄISCHE PATENTSCHRIFT

(11) **EP 1 002 349 B1**
(45) Veröffentlichungstag und Bekanntmachung des Hinweises auf die Patenterteilung: **27.06.2001**
(21) Anmeldenummer: 98948684.0
(22) Anmeldetag: 28.07.1998
(51) Int. Cl.: H01S 5/02, G02B 6/42

(54) **OPTISCHE SENDEEINRICHTUNG**
OPTICAL TRANSMISSION UNIT
UNITE D'EMISSION OPTIQUE

(30) Priorität: 08.08.1997 DE 19735925
(43) Veröffentlichungstag der Anmeldung: 24.05.2000
(73) Patentinhaber: Infineon Technologies AG, 81669 München (DE)
(72) Erfinder: STANGE, Herwig, D-14167 Berlin (DE)
(74) Vertreter: Müller, Wolfram Hubertus, Dipl.-Phys.
(86) Internationale Anmeldenummer: DE9802139
(87) Internationale Veröffentlichungsnummer: WO9908348

(56) Entgegenhaltungen:
- EP-A- 0 786 838
- EP-A- 0 786 839
- DE-A- 19 601 955
- US-A- 5 448 536

## Beschreibung

Die Erfindung liegt auf dem Gebiet lichtemittierender Sendeeinrichtungen, insbesondere für Zwecke der optischen Datenübertragung, die zur Leistungsregelung mit einer sog. Monitoreinheit ausgestattet sind. Für viele Anwendungen ist es nämlich wünschenswert, die Ausgangsleistung eines üblicherweise als Laser ausgebildeten Senders - unabhängig z. B. von Temperaturschwankungen und Alterungseffekten - möglichst konstant zu halten. Bei herkömmlichen, kanten- oder seitenabstrahlenden Lasern ist eine seitliche Anordnung einer Monitoreinheit vergleichsweise unproblematisch, weil die Monitoreinheit der nicht zur Abgabe von Nutzstrahlung vorgesehenen Laserseite oder Kante zugewandt angeordnet werden kann. Die an dieser Seite austretende (Verlust-)Strahlung wird so zu Regelungszwecken genutzt.

Neuere Entwicklungen und Fortschritte bei den Fertigungsverfahren ermöglichen zunehmend auch eine wirtschaftliche Herstellung sog. vertikal emittierender Sender (VCSEL = Vertical Cavity Surface Emitting Laser), die jedoch bei hohen Güteanforderungen an eine konstante Laserausgangsleistung ebenfalls eine Regeleinheit mit einer Monitoreinrichtung erfordern.

Im Hinblick auf diese Problematik ist in der WO 95/18479 einleitend ein Basisaufbau beschrieben, bei dem ein Bruchteil der von einem Sender (VCSEL) mit einer vertikal abstrahlenden Emissionszone emittierten Strahlung über einen Strahlteiler auf eine Monitoreinheit in Form eines Fotodetektors (Fotodiode) gelenkt wird. Das Ausgangssignal des Fotodetektors beaufschlagt eine Steuerschaltung, die gemäß dem Fotodetektorausgangssignal den Ansteuerstrom des Lasers derart beeinflußt, daß eine gewünschte Sendeausgangsleistung erreicht wird. Dieser Aufbau ist verhältnismäßig komplex.

Davon ausgehend beschreibt die WO 95/18479 eine optische Sendeeinrichtung, bei der ein vertikal emittierender Laser (VCSEL) einen integrierten Fotodetektor aufweist, der an der Unterseite des Lasers austretende Strahlung auswertet. Auch dieser Aufbau ist vergleichsweise aufwendig und setzt einen integralen Aufbau von Sender und Monitoreinheit voraus. Eine nachträgliche oder wahlweise Bestückung von vertikal abstrahlenden optischen Sendern mit einer Monitoreinheit ist danach nicht möglich.

Eine weitere Sendeeinrichtung ist aus der EP 0 786 838 A2 bekannt. Bei dieser bekannten Sendeeinrichtung (Figur 4E) ist zur Realisierung einer integrierten geregelten Laser-Lichtquelle ein vertikal abstrahlender Laser (VCSEL) als optischer Sender vorgesehen, der nur eine einzige senkrecht lichtabstrahlende Emissionszone aufweist. Ferner ist eine Monitoreinheit mit einer optisch sensitiven Empfangszone zur Leistungsregelung des optischen Senders vorgesehen. Ein zwischen einer Ankopplungszone, die beispielsweise von einer Lichtwellenleitersteckeraufnahme gebildet sein kann, einerseits und der Emissionszone sowie der Empfangszone andererseits ist ein Strahlteiler angeordnet, der senderseitig die emittierte Strahlung in einen Bruchteil und einen verbleibenden Teil aufteilt. Der verbleibende Teil wird als Nutzstrahlung zur Ankopplungszone hin abgegeben, während der Bruchteil auf die Empfangszone gelangt.

Die Aufgabe der Erfindung besteht daher in der Schaffung einer effizienten Kopplung eines optischen Senders mit vertikal emittierender Emissionszone mit der optisch sensitiven Empfangszone einer Monitoreinheit, wobei eine Formung der reflektierten Strahlung bei geringer Anzahl einzelner Bauteile und in kompakter Bauweise ermöglicht ist.

Diese Aufgabe wird erfindungsgemäß gelöst durch eine optische Sendeeinrichtung mit einem optischen Sender mit einer vertikal emittierenden Emissionszone, mit einer Monitoreinheit mit einer optisch sensitiven Empfangszone und mit einem Linsenkörper, der zwischen der Emissionszone und der Empfangszone einerseits und einer Ankopplungszone eines Kopplungspartners andererseits angeordnet ist, wobei über den Linsenkörper sowohl ein die Ankopplungszone treffender Anteil als auch ein ankopplungszonenseitig reflektierter und auf die Empfangszone treffender Anteil der von der Emissionszone emittierten Strahlung gelangt.

Ein erster wesentlicher Vorteil der erfindungsgemäßen Sendeeinrichtung besteht darin, daß der Linsenkörper in Doppelfunktion sowohl zur Lichteinkopplung in die Ankopplungszone oder -fläche des Kopplungspartners als auch zur Formung der auf die Monitoreinheit - d. h. auf deren optisch sensitive Fläche - gelangenden Strahlung dient. Da diese beiden Funktionen von einem einzigen Bauteil erfüllt werden, ist die erfindungsgemäße Sendeeinrichtung vorteilhafterweise mit wenigen Bauteilen und äußerst kompakt aufbaubar. Die Reflexion des Strahlungsanteils, der auf die Monitoreinheit zurückgeworfen werden soll, kann grundsätzlich auch durch ein zwischen Linsenkörper und Ankopplungszone vorgesehenes reflektierendes Element bewirkt werden.

Zu diesem Aspekt ist nach einer besonders bevorzugten Ausgestaltung der Erfindung jedoch vorgesehen, daß eine ankopplungszonenseitige Grenzfläche den Anteil der Strahlung zur Empfangszone hin reflektiert. Hier übernimmt der Linsenkörper mit seiner ankopplungszonenseitigen Grenzfläche eine weitere Funktion - nämlich die eines Reflektors - und trägt damit zu einer noch weiteren Verringerung der benötigten Bauteilanzahl und einer noch kompakteren Bauweise der Sendeeinrichtung bei.

Für viele praktische Realisierungen kann die Reflexion aufgrund des Unterschiedes der Brechungsindizes von Linsenkörper und äußerem ankopplungsseitigen Medium (z. B. Luft) genügen, um einen ausreichenden Strahlungsanteil zur Monitoreinheit zu reflektieren. Um besonders günstige und definierte Reflexionsverhältnisse zu gewährleisten, ist nach einer weiteren bevorzugten Ausgestaltung der erfindungsgemäßen Sendeeinrichtung die Grenzfläche teilverspiegelt. Dazu kann die Grenzfläche mit einer teildurchlässigen Spiegelschicht versehen sein und/oder ein Teil der Grenzfläche mit einem Spiegel versehen sein.

Eine hinsichtlich des radialen Platzbedarfs vorteilhafte Ausbildung der Erfindung sieht vor, daß die Emissionszone in Projektion entgegen der Emissionsrichtung gesehen innerhalb der Empfangszone liegt.

Eine alternative konstruktiv und aufbautechnisch bevorzugte Fortbildung der erfindungsgemäßen Sendeeinrichtung sieht vor, daß die Emissionszone und die Empfangszone in Projektion entgegen der Emissionsrichtung gesehen nebeneinander liegen.

Eine besonders kompakte Bauweise und eine definierte Aufweitung des die Empfangszone beaufschlagenden Strahlungsanteils läßt sich nach einer weiteren vorteilhaften Fortbildung der Erfindung dadurch realisieren, daß der zur Empfangszone hin reflektierte Strahlungsanteil einen Zwischenfokus aufweist. Hinsichtlich der Baugröße bevorzugt kann die Linsenkörpergeometrie derart ausgebildet sein, daß sich der Zwischenfokus im Linsenkörpermaterial befindet.

Nach einer weiteren vorteilhaften Ausbildung der erfindungsgemäßen Sendeeinrichtung hat die ankopplungsseitige Grenzfläche kegelmantelförmige Gestalt. Dadurch läßt sich in vorteilhafter Weise eine zur Z-Achse (Emissionsrichtung) symmetrische Einkopplung erreichen sowie eine ringförmige Empfangszone bestrahlen, deren Fläche nicht durch den optischen Sender abgedeckt ist.

Ausführungsbeispiele der Erfindung werden nachfolgend unter Bezugnahme auf eine Zeichnung weiter erläutert; es zeigen: Figuren 1 und 2 Strahlengänge einer ersten Sendeeinrichtung, Figuren 3 und 4 Strahlengänge einer zweiten Sendeeinrichtung und

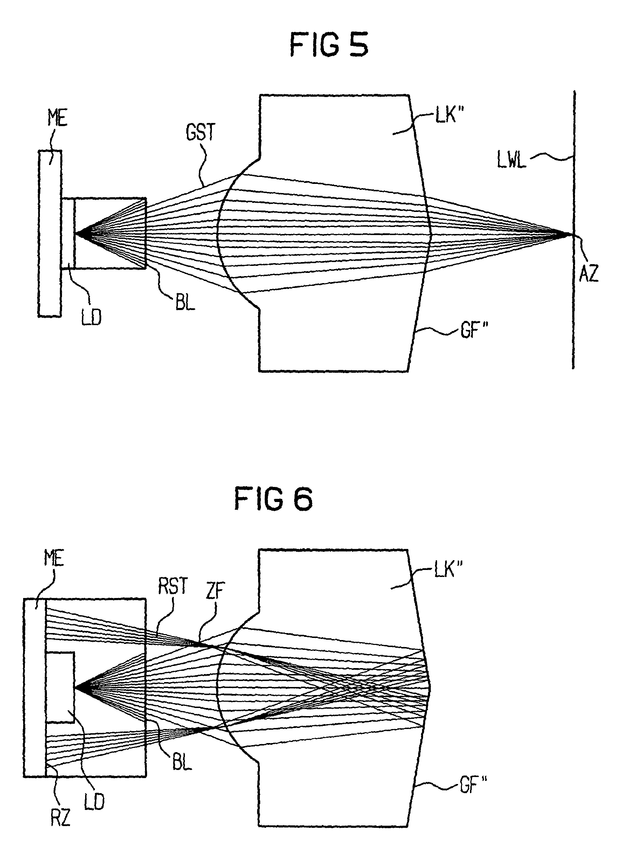

Figuren 5 und 6 Strahlengänge einer dritten Sendeeinrichtung.

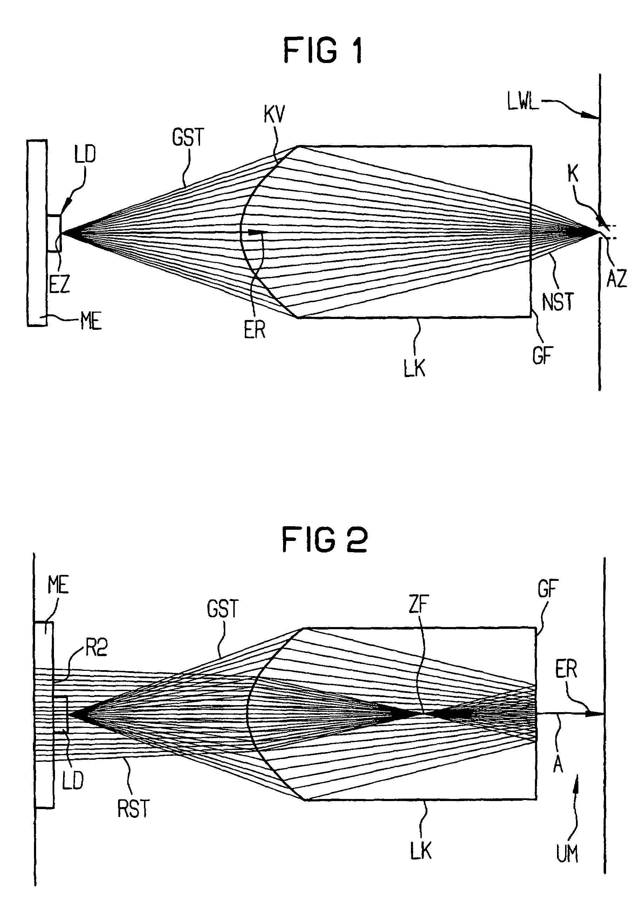

Figur 1 zeigt der Übersichtlichkeit halber nur den Strahlengang des von einem optischen Sender LD ausgehenden Anteils NST an Nutzstrahlung. Der optische Sender LD ist als vertikal emittierender Laser (VCSEL) mit einer Emissionszone EZ ausgebildet und strahlt senkrecht zu der Zone EZ ab. Die Gesamtstrahlung GST des Senders LD umfaßt - wie nachfolgend noch ausführlich erläutert - neben dem überwiegenden Nutzstrahlungsanteil NST einen Anteil RST (Figur 2), der über einen Linsenkörper LK in erwünschter Weise auf die Seite des Senders LD zurückgeworfen wird. Der Nutzstrahlungsanteil NST tritt über eine Ankopplungszone (Stirnfläche) AZ in den lichtleitenden Kern K eines Lichtwellenleiters LWL ein. Anstelle des Lichtwellenleiters LWL kann selbstverständlich auch ein anderes optisches oder elektrooptisches Element (Wandlerelement) als Kopplungspartner vorgesehen sein.

Der Nutzstrahlengang verläuft zumindest teilweise durch den Linsenkörper LK, der senderseitig - d. h. auf der dem Sender LD zugewandten Seite - eine Grenzfläche KV mit konvexer Form und ankopplungszonenseitig - d. h. auf der dem Kopplungspartner LWL zugewandten Seite - eine ebene Grenzfläche GF aufweist.

In Figur 2 ist dagegen nur der Verlauf desjenigen Anteils RST an der Gesamtstrahlung GST dargestellt, der durch den Linsenkörper LK in erwünschter Weise auf die Seite des Senders LD zurückgeworfen wird. Der Sender LD ist auf einer Monitoreinheit ME positioniert und zwar derart, daß die Emissionszone EZ und im Ausführungsbeispiel der gesamte Sender LD in Projektion entlang der optischen Achse A bzw. entgegen der Emissionsrichtung ER gesehen innerhalb einer Empfangszone RZ der Monitoreinheit ME liegt. Die Monitoreinheit ME dient in an sich bekannter Weise zur Regelung des Senders LD und insbesondere zur Kompensation temperaturabhängiger und/oder alterungsbedingter Leistungsänderungen. Die ankopplungszonenseitige Grenzfläche GF des Linsenkörpers LK ist derart ausgebildet, daß sie einen gegenüber der Nutzstrahlung NST (Figur 1) vergleichsweise geringen Anteil der ermittierten Strahlung GST von beispielsweise 5 % zur Empfangszone RZ zurückwirft. Der Anteil zu reflektierender Strahlung bemißt sich u. a. nach der gewünschten Leistungseinkopplung in den Kopplungspartner und der gewünschten Beaufschlagung der Monitoreinheit. Dazu kann die Grenzfläche GF teilverspiegelt sein, indem eine teildurchlässige Spiegelschicht auf die Grenzfläche aufgebracht wird. Es kann auch eine z. B. ringförmige, das Zentrum um die optische Achse freilassende Spiegelschicht auf der Grenzfläche GF' vorgesehen sein. Für viele Anwendungen ist aber bereits der Unterschied der Brechungsindizes des Linsenkörpers LK und des grenzflächigen Umgebungsmediums UM (beispielsweise Luft) ausreichend, um einen für die Zwecke einer Senderüberwachung und Sendersteuerung ausreichenden Strahlungsanteil RST zu reflektieren.

In Zusammenschau der Figuren 1 und 2 wird deutlich, daß sowohl die Nutzstrahlung NST als auch die zu Monitorzwecken zurückgeworfene Reflexionsstrahlung RST den zwischen der Emissionszone EZ und der Empfangszone RZ einerseits und der Ankopplungszone AZ (Figur 1) andererseits angeordneten Linsenkörper LK durchlaufen. Der Strahlungsanteil RST tritt dabei zunächst durch die senderseitige Grenzfläche KV in den Linsenkörper LK ein, wird an der kopplungspartnerseitigen Grenzfläche GF reflektiert und durchläuft den Linsenkörper LK erneut, um dann durch die Grenzfläche KV auszutreten, wobei er an der senderseitigen Grenzfläche KV eine weitere Strahlformung erfährt. Dabei weist die reflektierte Strahlung RST einen Zwischenfokus ZF innerhalb des Linsenkörpermaterials auf.

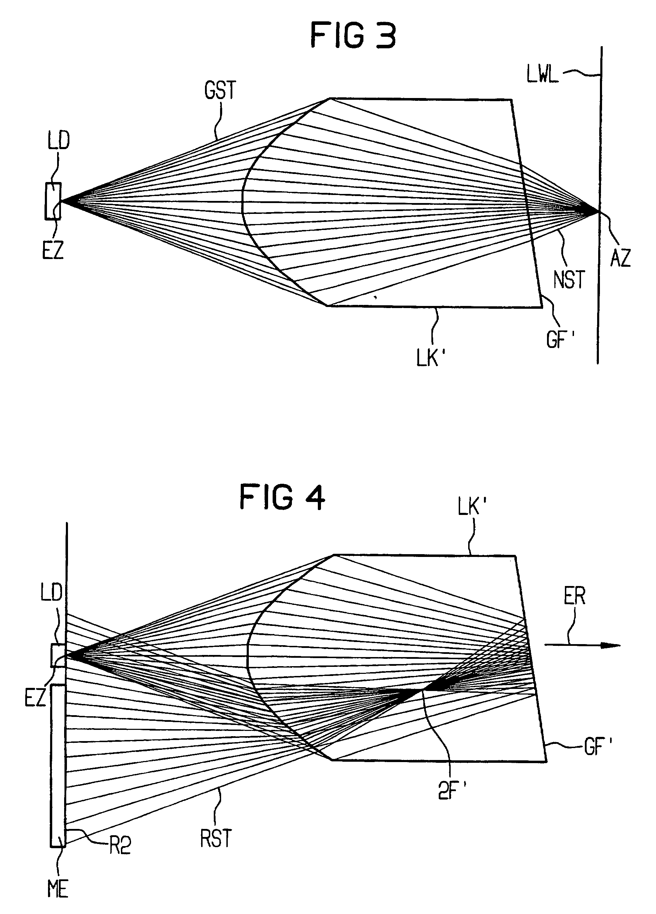

Die Figuren 3 und 4 zeigen eine Variante der erfindungsgemäßen Sendeeinrichtung, die insbesondere durch eine gegenüber der in den Figuren 1 und 2 gezeigten Ausgestaltung veränderte kopplungspartnerseitige Grenzfläche GF' geprägt ist (bei der nachfolgenden Figurenbeschreibung sind identische oder gleichartige Elemente mit denselben Bezugszeichen versehen). Figur 3 zeigt aus Gründen der Übersichtlichkeit nur den in der Gesamtstrahlung GST enthaltenen Anteil NST der Nutzstrahlung, der über eine gegenüber der Ankopplungszone AZ des Lichtwellenleiters LWL geschrägte Grenzfläche GF' in die Ankopplungszone des Lichtwellenleiters LWL eintritt.

Wie unter Bezugnahme auf Figur 4, die in der Figur 2 entsprechender Darstellungsweise nur den reflektierten Strahlungsanteil RST zeigt, deutlich wird, führt die geschrägte Ausgestaltung der Grenzfläche GF' hinsichtlich der Reflexion des Strahlungsanteils RST dazu, daß dieser nicht symmetrisch in bezug auf den Sender LD bzw. dessen Emissionszone EZ zurückgeworfen wird, sondern überwiegend neben dem Sender LD auftrifft. Demgemäß ist die als Monitordiode ausgebildete Monitoreinheit ME mit ihrer Empfangszone RZ in Projektion entgegen der Emissionsrichtung ER gesehen neben dem Sender LD angeordnet. Auch bei diesem Ausführungsbeispiel hat der Anteil reflektierter Strahlung RST einen Zwischenfokus ZF' innerhalb des Materials des Linsenkörpers LK'.

Das in den Figuren 5 und 6 ebenfalls in Trennung der Strahlungsanteile NST, RST gezeigte Ausführungsbeispiel ist durch eine weitere Modifikation des Linsenkörpers LK" auf der Seite der Ankopplungszone AZ geprägt. Bei dieser Ausgestaltung ist der Sender LD wiederum auf der Monitoreinheit ME montiert. Die Grenzfläche GF" des Linsenkörpers LK" hat kegelmantelförmige Gestalt, deren Auswirkungen insbesondere aus dem in Figur 6 gezeigten längssymmetrischen Verlauf der reflektierten Strahlung RST hervorgeht. Der wesentliche Anteil der Gesamtstrahlung GST" gelangt als Nutzstrahlung NST" auf die Ankopplungszone AZ des Kopplungspartners LWL (Figur 5).

Der reflektierte Anteil RST (Figur 6) bildet einen ringlinienförmigen Zwischenfokus ZF außerhalb des Linsenkörpers LK" und erweitert sich dann derart, daß eine die optisch sensitive Empfangszone RZ ringkreisförmig mit der reflektierten Strahlung RFT" beaufschlagt wird. Diese Ausgestaltung läßt eine besonders kompakte Bauform bei wirkungsvoller Lichtbeaufschlagung der Monitoreinheit ME zu.

Allen Ausführungsbeispielen gemeinsam ist, daß die reflektierte Strahlung im Bereich der Monitoreinheit und damit ggf. im Bereich des gegenüber reflektierter Strahlung möglicherweise empfindlichen Senders (insbesondere bei Lasern) aufgeweitet ist. Dadurch ist die reflektierte Strahlung in ihrer Flächenintensität so vermindert, daß eine Schädigung des Sensors durch bei teilweise auf diesen auftreffende reflektierte Strahlung nicht zu befürchten ist. In dieser Hinsicht sind insbesondere die Ausführungsbeispiele nach den Figuren 3 bis 6 vorteilhaft, wobei gemäß der Ausführung in den Figuren 5 und 6 überhaupt keine Reflexionsbelastung des Senders vorliegt. Der Linsenkörper kann durch Einsatz diffraktiver statt refraktiver Optik unter Beibehaltung der zuvor beschriebenen Funktionen modifiziert werden. Eine kostengünstige Realisierung ist insbesondere unter Verwendung von Kunststofflinsenkörpern möglich. Der Linsenkörper kann auch als mehrteiliges Linsenelement ausgebildet sein.

Die erfindungsgemäße Sendeeinrichtung zeichnet sich u. a. dadurch aus, daß die für die Überwachung der Sendeleistung und die für die Einkopplung der Nutzstrahlung erforderlichen Strahlformungen von einem einzigen Bauteil - nämlich dem Linsenkörper LK - erfüllt werden. Der zwischen Sender sowie Monitoreinheit auf der einen und dem Kopplungspartner auf der anderen Seite zwischengeordnete Linsenkörper fokussiert den Nutzanteil der emittierten Strahlung auf die Ankopplungszone und bildet einen Teil der emittierten Strahlung über die Reflexion an der vorzugsweise teilverspiegelten Grenzfläche auf der Kopplungspartnerseite auf die Monitoreinrichtung ab. Die Sendeeinrichtung ermöglicht eine sehr effiziente Ankopplung der Monitoreinheit bei geringer Bauteilanzahl und einer sehr kompakten Bauweise.

## Patentansprüche

1. Optische Sendeeinrichtung
- mit einem optischen Sender (LD) mit einer vertikal emittierenden Emissionszone (EZ),
- mit einer Monitoreinheit (ME) mit einer optisch sensitiven Empfangszone (RZ)
- und mit einem Linsenkörper (LK), der zwischen der Emissionszone (EZ) sowie der Empfangszone (RZ) einerseits und einer Ankopplungszone (AZ) eines Kopplungspartners (LWL) andererseits angeordnet ist,
- wobei über den Linsenkörper (LK) sowohl ein die Ankopplungszone (AZ) treffender Anteil (NST) als auch ein ankopplungszonenseitig reflektierter und auf die Empfangszone (RZ) treffender Anteil (RST) der von der Emissionszone (EZ) emittierten Strahlung (GST) gelangt.

2. Sendeeinrichtung nach Anspruch 1,
**dadurch gekennzeichnet, daß**
eine ankopplungszonenseitige Grenzfläche (GF) des Linsenkörpers (LK) den einen Anteil (RST) der Strahlung (GST) zur Empfangszone (RZ) hin reflektiert.

3. Sendeeinrichtung nach Anspruch 2,
**dadurch gekennzeichnet, daß**
die Grenzfläche (GF) teilverspiegelt ist.

4. Sendeeinrichtung nach einem der vorangehenden Ansprüche,
**dadurch gekennzeichnet, daß**
die Emissionszone (EZ) in Projektion entgegen der Emissionsrichtung (ER) gesehen innerhalb der Empfangszone (RZ) liegt.

5. Sendeeinrichtung nach Anspruch 1, 2 oder 3,
**dadurch gekennzeichnet, daß**
die Emissionszone (EZ) und die Empfangszone (RZ) in Projektion entgegen der Emissionsrichtung (ER) gesehen nebeneinander liegen.

6. Sendeeinrichtung nach einem der vorangehenden Ansprüche,
**dadurch gekennzeichnet, daß**
der zur Empfangszone (RZ) hin reflektierte Strahlungsanteil (RST) einen Zwischenfokus (ZF) aufweist.

7. Sendeeinrichtung nach einem der Ansprüche 2 bis 6,
**dadurch gekennzeichnet, daß**
die ankopplungszonenseitige Grenzfläche (GF") kegelmantelförmige Gestalt hat.

## Claims

1. Optical transmitting device
- having an optical transmitter (LD) with a vertically emitting emission zone (EZ),
- having a monitor unit (ME) with an optically sensitive reception zone (RZ)
- and having a lens member (LK) which is arranged, on the one hand, between the emission zone (EZ) and the reception zone (RZ) and, on the other hand, a coupling zone (AZ) of a coupling partner (LWL),
- there passing via the lens member (LK) both a component (NST), striking the coupling zone (AZ), of the radiation (GST) emitted by the emission zone (EZ), and a component (RST) of the said radiation reflected on the coupling zone side and striking the reception zone (RZ).

2. Transmitting device according to Claim 1, characterized in that a boundary surface (GF), on the coupling zone side, of the lens member (LK) reflects one component (RST) of the radiation (GST) towards the reception zone (RZ).

3. Transmitting device according to Claim 2, characterized in that the boundary surface (GF) is partially silvered.

4. Transmitting device according to one of the preceding claims, characterized in that the emission zone (EZ) is situated inside the reception zone (RZ) when seen projected against the emission direction (ER).

5. Transmitting device according to Claim 1, 2 or 3, characterized in that the emission zone (EZ) and the reception zone (RZ) are situated next to one another when seen projected against the emission direction (ER).

6. Transmitting device according to one of the preceding claims, characterized in that the radiation component (RST) reflected towards the reception zone (RZ) has an intermediate focus (ZF) .

7. Transmitting device according to one of Claims 2 to 6, characterized in that the boundary surface (GF'') on the coupling zone side has the shape of a conical envelope.

## Revendications

1. Dispositif d'émission optique
- comportant un émetteur (LD) optique ayant une zone (EZ) d'émission émettant verticalement,
- comportant une unité (ME) de moniteur ayant une zone (RZ) de réception sensible du point de vue optique
- et comportant un élément (LK) de lentille qui est disposé entre la zone (EZ) d'émission ainsi que la zone (RZ) de réception, d'une part, et une zone (AZ) de raccordement d'un partenaire (LWL) de couplage, d'autre part,
- tant une composante (NST) rencontrant la zone (AZ) de raccordement qu'une composante (RST) réfléchie du côté de la zone de raccordement et arrivant sur la zone (RZ) de réception du faisceau (GST) émis par la zone (EZ) d'émission arrivant par l'intermédiaire de l'élément (LK) de lentille.

2. Dispositif d'émission suivant la revendication 1, caractérisé en ce qu'une surface (GF) limite de l'élément (LK) de lentille, située du côté de la zone de raccordement, réfléchit l'une des composantes (RST) du faisceau (GST) vers la zone (RZ) de réception.

3. Dispositif d'émission suivant la revendication 2, caractérisé en ce que la surface (GF) limite est munie en partie d'une couche réfléchissante.

4. Dispositif d'émission suivant l'une des revendications précédentes, caractérisé en ce que la zone (EZ) d'émission se trouve, vue en projection en sens inverse de la direction (ER) d'émission, à l'intérieur de la zone (RZ) de réception.

5. Dispositif d'émission suivant la revendication 1, 2 ou 3, caractérisé en ce que la zone (EZ) d'émission et la zone (RZ) de réception se trouvent côte à côte vues en projection en sens inverse du sens (ER) d'émission.

6. Dispositif d'émission suivant l'une des revendications précédentes, caractérisé en ce que la composante (RST) de faisceau réfléchie vers la zone (RZ) de réception comporte un foyer (ZF) intermédiaire.

7. Dispositif d'émission suivant l'une des revendications 2 à 6, caractérisé en ce que la surface (GF") limite située du côté de la zone de raccordement a une forme de surface latérale de cône.
